# EUROPÄISCHE PATENTSCHRIFT

(11) **EP 0 903 639 B1**
(45) Veröffentlichungstag und Bekanntmachung des Hinweises auf die Patenterteilung: **14.05.2003**
(21) Anmeldenummer: 98116860.2
(22) Anmeldetag: 07.09.1998
(51) Int. Cl.: G03F 7/20, G03F 7/038

(54) **Herstellung von strukturierten Schutz- und Isolierschichten**
Process of making patterned protective and insulating layers
Procédé de fabrication de couches protectrices et isolantes structurées

(30) Priorität: 18.09.1997 DE 19741230
(43) Veröffentlichungstag der Anmeldung: 24.03.1999
(73) Patentinhaber: Osram Opto Semiconductors GmbH & Co. OHG, 93049 Regensburg (DE)
(72) Erfinder: Sezi, Recai, Dr., 91341 Röttenbach (DE); Günther, Ewald, Dr., 981074 Herzogenaurach (DE); Keitmann, Michael, Dipl.-Chem., 91074 Herzogenaurach (DE)
(74) Vertreter: Epping, Wilhelm, Dipl.-Ing.

(56) Entgegenhaltungen:
- EP-A- 0 264 678
- US-A- 4 927 736
- HIRAOKA H ET AL: "UV hardening of photo- and electron beam resist patterns" JOURNAL OF VACUUM SCIENCE & TECHNOLOGY , Bd. 19, Nr. 4, 1981, Seiten 1132-1135, XP002101961

## Beschreibung

Die Erfindung betrifft ein Verfahren zur Herstellung strukturierter Schutz- und Isolierschichten.

Zum Schutz von mikroelektronischen und optoelektronischen Bauelementen gegen externe Einflüsse, wie Feuchtigkeit, werden die Bauelemente zunächst mit einer strukturierten Pufferschicht ("buffer coating") und dann mit einer Preß- bzw. Vergußmasse versehen. Wegen deutlicher Kostenvorteile bei der Strukturierung werden bei der Herstellung der Pufferschichten photosensitive Materialien gegenüber nicht-photosensitiven Materialien bevorzugt. Insbesondere bei optoelektronischen Bauelementen ist eine ausreichende Transparenz der Pufferschicht (und auch der Vergußmasse) von großer Bedeutung. Aber auch bei mikroelektronischen Bauelementen, die keine transparente Preßmasse erfordern, ist eine gute Transparenz der Pufferschicht wichtig, weil die zur Unterscheidung der guten und schlechten Chips aufgebrachte Markierung bei einem transparenten Material einfacher zu erkennen ist.

Bislang dienen Polyimide, die durch Tempern von photosensitiven Polyimid-Vorstufen hergestellt werden, als Material für Pufferschichten (siehe: D.S. Soane, Z. Martynenko "Polymers in Microelectronics - Fundamentals and Applications", Elsevier Science Publishers B.V., Amsterdam 1989, Seiten 1 bis 13). Derartige Polyimide weisen aber (nach dem Tempern) keine ausreichende Transparenz auf, außerdem muß bei der Strukturierung der Vorstufen nach dem negativen Modus gearbeitet werden und die Entwicklung muß mit organischen Lösemitteln erfolgen.

Aufgabe der Erfindung ist es, ein Verfahren anzugeben, das die Herstellung von strukturierten Schutz- und Isolierschichten, insbesondere Pufferschichten, erlaubt, die - neben einer hohen Auflösung und einer geringen Feuchteaufnahme - vor allem eine hohe Transparenz aufweisen.

Dies wird erfindungsgemäß in folgender Weise erreicht:
- Auf ein Substrat, das insbesondere ein Wafer ist, wird eine Lösung eines photosensitiven Polyhydroxyamids oder Polyhydroxyimids aufgebracht und zu einer Schicht getrocknet,
- die Schicht wird durch Bestrahlen mit UV-Licht oder Röntgenstrahlen mittels einer Maske oder durch Führen eines UV- oder Elektronenstrahls und durch nachfolgende wäßrigalkalische Entwicklung strukturiert,
- die strukturierte Schicht wird ganzflächig mit UV-Licht bestrahlt und dann getempert.

Das Verfahren nach der Erfindung, das insbesondere zur Herstellung von Pufferschichten dient, liefert Schichten, die aus Polybenzoxazol (PBO) oder Polyhydroxyimid bestehen. Zur Herstellung von Schichten aus Polybenzoxazol werden photosensitive PBO-Vorstufen eingesetzt, nämlich photosensitive Polyhydroxyamide. Diese PBO-Vorstufen werden photostrukturiert, beispielsweise mittels einer Maske, und getempert, wobei eine Cyclisierung zum Polybenzoxazol erfolgt.

Wesentlich ist beim Verfahren nach der Erfindung, daß vor dem Tempern eine ganzflächige Bestrahlung durchgeführt wird, eine sogenannte Flutbelichtung, d.h. eine Bestrahlung ohne Maske. Dadurch wird überraschenderweise erreicht, daß die nach dem Tempern erhaltenen Polymeren eine hohe Transparenz aufweisen Im Vergleich mit Polyimiden bieten diese Polymeren, die hochtemperaturstabil ist, den weiteren Vorteil, daß die Vorstufen nach dem positiven Modus strukturierbar sind und wäßrig-alkalisch entwickelt werden können; bei Polybenzoxazol ist außerdem die Feuchteaufnahme geringer.

Bei der Herstellung der strukturierten Schutz- und Isolierschichten nach der Erfindung haben sich folgende Maßnahmen als vorteilhaft erwiesen:
- Die ganzflächige Bestrahlung wird mit einer höheren Strahlendosis durchgeführt als die strukturierende Bestrahlung.
- Zur strukturierenden Bestrahlung und zur ganzflächigen Bestrahlung dient UV-Licht, insbesondere mit einer Wellenlänge λ > 200 nm.
- Die strukturierende Bestrahlung mit UV-Licht, beispielsweise unter Verwendung eines Lasers, erfolgt mit einer Strahlendosis von 200 bis 2000 mJ/cm².
- Die Temperung erfolgt bei einer Temperatur T ≥ 250°C.

Bei der Bestrahlung mit Röntgenstrahlen beträgt die Strahlendosis vorzugsweise 1 bis 100 mJ/cm², bei der Bestrahlung mit Elektronenstrahlen vorzugsweise 10 bis 1000 µC/cm².

Anhand von Ausführungsbeispielen soll die Erfindung noch näher erläutert werden.

### Beispiel 1

### Transmissionsvergleich von Polybenzoxazol und Polyimid

Für die Untersuchungen werden drei photosensitive Lösungen verwendet:
(1) Eine kommerziell erhältliche photosensitive PBO-Lösung (CRC 8200, Fa. Sumitomo) auf der Basis von Polyhydroxyamid, die direkt, d.h. unverändert, eingesetzt wird.
(2) Eine photosensitive PBO-Lösung auf der Basis von Polyhydroxyamid, die 8 g einer PBO-Vorstufe und 2 g eines Diesters aus Bisphenol A und Naphthochinondiazid-5-sulfonsäure in 30 ml N-Methylpyrrolidon enthält. Die PBO-Vorstufe wurde entsprechend EP 0 761 718 A2 (Beispiel 5) hergestellt. Die Herstellung der photosensitiven Lösung kann auch entsprechend dem in EP 0 264 678 A1 beschriebenen Verfahren erfolgen.
(3) Eine kommerziell erhältliche photosensitive Polyimidlösung (PI 7510, Fa. Olin), die unverändert eingesetzt wird.

### Beschichtung von Quarzwafern:

Quarzwafer werden in N-Methylpyrrolidon und Aceton gereinigt und 15 min auf einer Heizplatte bei 160°C ausgeheizt. Die photosensitiven Lösungen werden mittels einer Spritze durch ein 0,2 µm-Filter auf die Quarzwafer aufgetragen und in einer Schleuderapparatur zu Filmen geschleudert. Diese Filme werden dann 60 s bei 90°C und 240 s bei 120°C getrocknet.

### Belichtung der Quarzwafer:

Drei unter Verwendung der Lösungen (1) bis (3) unterschiedlich beschichtete Quarzwafer werden zusammen in einer Belichtungsapparatur (MA4, Fa. Süss) mittels UV-Licht einer Wellenlänge von 250 bis 450 nm ohne Maske belichtet (Flutbelichtung); Belichtungsdosis: 600 mJ/cm².

### Temperung der Quarzwafer:

Die belichteten Quarzwafer werden in einem Laborofen (Sirius Junior, Fa. LP-Thermtech) unter Stickstoff getempert. Das Temperprogramm ist für alle zu untersuchenden Wafer gleich und auf eine Temperatur von 350°C eingestellt (Dauer: 1 h); die Aufheiz- und Abkühlraten betragen jeweils 5 K/min. Die erhaltenen Polymerschichten weisen eine Schichtdicke von 6 µm auf.

### Transmissionsuntersuchung der Polymerschichten:

Die Untersuchungen erfolgen UV-spektroskopisch mit einem UV/VIS-Gerät (UV 260, Fa. Shimadzu); die Startwellenlänge beträgt 350 nm, die Endwellenlänge 650 nm. Dabei wird die Transmission der Polymerschichten in Abhängigkeit von der Wellenlänge ermittelt.

Für die Transmission der belichteten Schichten nach dem Tempern ergibt sich folgendes:

| | Polymer aus Lösung | | |
|---|---|---|---|
| Wellenlänge | (1) | (2) | (3) |
| 400 nm | 82 % | 82 % | 12 % |
| 450 nm | 88 % | 88 % | 33 % |
| 500 nm | 90 % | 90 % | 50 % |
| 550 nm | 96 % | 96 % | 61 % |

Ab einer Wellenlänge von 500 nm beträgt die Transmission der mit Polybenzoxazol beschichteten Quarzwafer ≥ 90 %.

Bezüglich der Transmission der unbelichteten Schichten nach dem Tempern ergibt sich folgendes:
Beim Polymer aus Lösung (3) ist die Transmission die gleiche wie diejenige des belichteten Materials.
Die Transmission von Polymeren aus den Lösungen (1) und (2) ist bei allen vorstehend angegebenen Wellenlängen geringer als bei dem Polymer aus Lösung (3).

Entsprechende Ergebnisse wie bei den PBO-Lösungen (1) und (2), und zwar sowohl bei belichteten als auch bei unbelichteten Schichten, werden dann erhalten, wenn eine Lösung eines photosensitiven Polyhydroxyimids, beispielsweise nach der US-PS 4 927 736, verwendet wird.

### Beispiel 2

Auf einen 3"-Siliziumwafer (mit (100)-Orientierung) werden - ohne weitere Vorbehandlung - 2 ml der photosensitiven PBO-Lösung (1) aufgebracht (siehe Beispiel 1). Mittels eines Spincoaters (Fa. Convac) wird in einem zweistufigen Prozeß (10 s mit 500 Umdrehungen pro Minute und 30 s mit 3000 Umdrehungen pro Minute) überschüssiges Material abgeschleudert und eine homogene Schicht hergestellt. Diese Schicht wird auf einer Heizplatte 60 s bei 90°C und 240 s bei 120°C getrocknet; die mittlere Schichtdicke beträgt dann 6,5 µm. Nachfolgend wird die Schicht mittels einer Kontaktbelichtungsapparatur (MA4, Fa. Süss) mit UV-Licht mit einer Dosis von 300 mJ/cm² polychromatisch belichtet. Die Strukturerzeugung erfolgt dabei mit einer üblichen Glas/Chrom-Lithographiemaske. Anschließend wird die Schicht mit einem wäßrig-alkalischen Entwickler (NMD-W 2,38 %, Fa. Tokyo Oka, im Verhältnis 1:1 mit Wasser verdünnt) auf einer Schleuder entwickelt. Dabei werden bei nicht-rotierendem Wafer 20 ml Entwicklerlösung aufgegossen, die man 40 s lang einwirken läßt, und dann wird 5 s bei 3000 Umdrehungen pro Minute abgeschleudert; dieser Vorgang wird einmal wiederholt. Nachfolgend läßt man den Wafer 30 s mit 3000 Umdrehungen pro Minute rotieren, wobei während der ersten 15 s gründlich mit Wasser gespült wird. Die belichteten Bereiche sind dann entfernt (positives System).

Anschließend erfolgt - unter Verwendung der gleichen Kontaktbelichtungsapparatur - die Belichtung ohne Lithographiemaske; die Belichtungsdosis beträgt hierbei 600 mJ/cm². Die resultierende Schicht mit einer mittleren Schichtdicke von 6,2 µm wird dann in einem Laborofen (Sirius Junior, Fa. LP Thermtech) getempert, wobei die PBO-Vorstufe zum Polybenzoxazol cyclisiert. Beginnend bei 100°C wird dabei linear über 10 min auf 150°C aufgeheizt; diese Temperatur wird für 30 min konstant gehalten. Dann wird - wieder linear - über 35 min auf 350°C aufgeheizt und diese Temperatur für 60 min konstant gehalten. Nachfolgend wird über 45 min linear auf 100°C abgekühlt. Die dabei erhaltene Schicht weist eine mittlere Dicke von 4,7 µm auf, sie zeigt die ausgezeichneten mechanischen Eigenschaften von PBO und ist zusätzlich noch optisch transparent.

### Beispiel 3

Auf einen fertig prozessierten Wafer mit GaN-Leuchtdioden werden - ohne weitere Vorbehandlung - über ein Spritzenfilter mit 1 µm Porengröße 5 ml der photosensitiven PBO-Lösung (1) aufgebracht (siehe Beispiel 1). Mittels eines Spincoaters (Fa. Convac) wird in einem zweistufigen Prozeß (10 s mit 500 Umdrehungen pro Minute und 30 s mit 2200 Umdrehungen pro Minute) überschüssiges Material abgeschleudert und eine homogene Schicht hergestellt. Diese Schicht wird auf einer Heizplatte 60 s bei 90°C und 240 s bei 120°C getrocknet; die mittlere Schichtdicke beträgt dann 8,4 µm. Nachfolgend wird die Schicht mittels einer Kontaktbelichtungsapparatur (MA4, Fa. Süss) mit UV-Licht mit einer Dosis von 450 mJ/cm² polychromatisch belichtet. Die Strukturerzeugung erfolgt dabei mit einer üblichen Glas/Chrom-Lithographiemaske, wobei die Öffnungen in der Maske über die Kontaktflächen der Dioden justiert werden. Anschließend wird die Schicht mit einem wäßrig-alkalischen Entwickler (NMD-W 2,38 %, Fa. Tokyo Oka, im Verhältnis 1:1 mit Wasser verdünnt) auf einer Schleuder entwickelt. Dabei werden bei nicht-rotierendem Wafer 20 ml Entwicklerlösung aufgegossen, die man 40 s lang einwirken läßt, und dann wird 5 s bei 3000 Umdrehungen pro Minute abgeschleudert; dieser Vorgang wird einmal wiederholt. Nachfolgend läßt man den Wafer 30 s mit 3000 Umdrehungen pro Minute rotieren, wobei während der ersten 15 s gründlich mit Wasser gespült wird.

Anschließend erfolgt - unter Verwendung der gleichen Kontaktbelichtungsapparatur - die Belichtung ohne Lithographiemaske; die Belichtungsdosis beträgt hierbei 600 mJ/cm². Die resultierende Schicht mit einer mittleren Schichtdicke von 8,1 µm wird dann in einem Laborofen (Sirius Junior, Fa. LP Thermtech) getempert, wobei die PBO-Vorstufe zum Polybenzoxazol cyclisiert. Beginnend bei 100°C wird dabei linear über 10 min auf 150°C aufgeheizt; diese Temperatur wird für 30 min konstant gehalten. Dann wird - wieder linear - über 35 min auf 350°C aufgeheizt und diese Temperatur für 60 min konstant gehalten. Nachfolgend wird über 45 min linear auf 100°C abgekühlt. Die dabei erhaltene Schicht weist eine mittlere Dicke von 6,1 µm auf, sie zeigt die ausgezeichneten mechanischen Eigenschaften von PBO und ist zusätzlich noch optisch transparent.

## Patentansprüche

1. Verfahren zur Herstellung strukturierter Schutz- und Isolierschichten, **gekennzeichnet durch** folgende Schritte:
- auf ein Substrat wird eine Lösung eines photosensitiven Polyhydroxyamids oder Polyhydroxyimids aufgebracht und getrocknet,
- die Schicht wird **durch** Bestrahlen mit UV-Licht oder Röntgenstrahlen mittels einer Maske oder **durch** Führen eines UV- oder Elektronenstrahls und **durch** nachfolgende wäßrigalkalische Entwicklung strukturiert,
- die strukturierte Schicht wird ganzflächig mit UV-Licht bestrahlt und dann getempert.

2. Verfahren nach Anspruch 1, **dadurch gekennzeichnet, daß** die ganzflächige Bestrahlung mit einer höheren Strahlendosis erfolgt als die strukturierende Bestrahlung.

3. Verfahren nach Anspruch 1 oder 2, **dadurch gekennzeichnet, daß** zur strukturierenden Bestrahlung und zur ganzflächigen Bestrahlung UV-Licht dient, insbesondere mit einer Wellenlänge λ > 200 nm.

4. Verfahren nach einem der Ansprüche 1 bis 3, **dadurch gekennzeichnet, daß** bei der strukturierenden Bestrahlung mit UV-Licht die Strahlendosis 200 bis 2000 mJ/cm² beträgt.

5. Verfahren nach einem oder mehreren der Ansprüche 1 bis 4, **dadurch gekennzeichnet, daß** bei einer Temperatur T ≥ 250°C getempert wird.

## Claims

1. Process for fabricating patterned protective and insulating layers, **characterized by** the following steps:
- a solution of photosensitive polyhydroxyamide or polyhydroxyimide is applied to a substrate and dried,
- the layer is patterned by irradiation with UV light or X-rays by means of a mask or by guidance of a UV or electron beam and by subsequent aqueous-alkali development,
- the patterned layer is irradiated over the whole area with UV light and then heat-treated.

2. Process according to Claim 1, **characterized in that** the whole-area irradiation is carried out with a higher radiation dose than the patterning irradiation.

3. Process according to Claim 1 or 2, **characterized in that** UV light is used for the patterning irradiation and for the whole-area irradiation, in particular UV light having a wavelength λ > 200 nm.

4. Process according to one of Claims 1 to 3, **characterized in that**, in the course of patterning irradiation with UV light, the radiation dose is 200 to 2000 mJ/cm².

5. Process according to one or more of Claims 1 to 4, **characterized in that** the heat-treatment is effected at a temperature T ≥ 250°C.

## Revendications

1. Procédé pour la fabrication de couches structurées de protection et d'isolation, **caractérisé par** les étapes suivantes :
- une solution photosensible d'un polyhydroxyamide ou de polyhydroxyimide est appliquée sur un substrat et séchée,
- la couche est structurée par irradiation avec de la lumière UV ou avec des rayons X au moyen d'un masque ou en guidant un faisceau d'UV ou d'électrons et par développement alcalin humide ultérieur
- la couche structurée est irradiée sur toute sa surface avec de la lumière UV et ensuite recuite.

2. Procédé selon la revendication 1, **caractérisé en ce que** l'irradiation de toute la surface est réalisée avec une dose de rayonnement supérieure à l'irradiation structurante.

3. Procédé selon la revendication 1 ou 2, **caractérisé en ce qu'**on utilise de la lumière UV, en particulier avec une longueur d'onde λ > 200 nm pour l'irradiation structurante et pour l'irradiation de toute la surface.

4. Procédé selon une des revendications 1 à 3, **caractérisé en ce que** la dose de rayonnement soit de 200 à 2000 mJ/cm² lors de l'irradiation structurante avec de la lumière UV.

5. Procédé selon une ou plusieurs des revendications 1 à 4, **caractérisé en ce qu'**on recuit à une température T ≥ 250°C.
